# EUROPEAN PATENT APPLICATION

(11) **EP 4 101 581 A1**
(43) Date of publication of application: **14.12.2022**
(21) Application number: 21179030.8
(22) Date of filing: 11.06.2021
(51) Int. Cl.: B23Q 1/36, G02B 7/00, G03F 7/20, H01L 21/68

(54) **FLEXURE-BASED PLANAR XY TRANSITION TABLE**

(71) Applicant: Ecole Polytechnique Fédérale de Lausanne (EPFL), 1015 Lausanne (CH)
(72) Inventor: FLÜCKIGER, Patrick, 1955 Chamoson (CH); BAUR, Charles, 2024 ST-AUBIN SAUGES (CH); SCHNEEGANS, Hubert, 2024 ST-AUBIN SAUGES (CH)
(74) Representative: e-Patent SA

(57) **Abstract**

Flexure mechanism (1) comprising:
- an end effector (3) arranged to be able to move in a first plane (XY);
- an intermediate stage (7) linked to said end effector (3) by means of at least three first beams (5) extending substantially perpendicular to said first plane (XY) when the flexure mechanism (1) is in an unstressed state, said intermediate stage (7) being arranged to at least translate parallel to said first plane (XY);
- a first fixed element (11) linked to said intermediate stage (5) by means of at least three second beams (9) extending substantially perpendicular to said first plane (XY) when the flexure mechanism (1) is in an unstressed state;
- a coupling arrangement (13, 13a, 13b; 13c) linked to said end effector (3), to said intermediate stage (7), and to a fixed element (11, 15,29), said coupling arrangement (13, 13a, 13b; 13c) being arranged so as to substantially prevent said end effector (3) from displacing perpendicular to said first plane (XY).

## Description

### Technical Field

The present invention relates to the field of flexure mechanisms. More particularly, it relates to a flexure-based XY transition table with two degrees of freedom in translation.

### State of the art

Many examples of XY translation tables are known in the prior art for various applications, which comprise an end effector which can move with substantially only two degrees of freedom in translation in a plane (defined as the XY plane). Various constructions are known, such as the planar constructions disclosed in documents US6817104 and US2011255182. Such planar constructions are often favoured since they are particularly easy to fabricate from a plate of material (metals, silicon, silicon carbide, nitride or oxide, alumina, ceramics, glasses and so on) by wire EDM, etching and similar processes. In general, such XY translation tables are typically used in conjunction with actuators in order to position an object with respect to a fixed reference, but this does not have to be the case.

However, known constructions present various drawbacks. Typically, parasitic displacements in translation or rotation with respect to other axes are present, particularly at high displacements or high loads. In particular, in the case of planar constructions based around blade flexures, significant deformation in the Z direction (perpendicular to the XY plane) is obtained at high loads, and relatively high displacements can also induce rotation of the end actuator about various axes, depending on the geometry of the flexure arrangement used.

An object of the present invention is hence to propose a flexure-based XY translation table mechanism in which the above-mentioned drawbacks are at least partially overcome.

### Disclosure of the invention

More precisely, the invention relates to a flexure mechanism as defined in claim 1. This flexure mechanism comprises:
- an end effector arranged to be able to move in a first plane, i.e. to act as an XY translation table;
- an intermediate stage linked to said end effector by means of at least three first beams extending substantially perpendicular to said first plane when the flexure mechanism is in an unstressed state, said intermediate stage being arranged to translate parallel to said first plane (and also to translate and rotate parasitically in/around other directions) ;
- a first fixed element linked to said intermediate stage by means of at least three second beams extending substantially perpendicular to said first plane when the flexure mechanism is in an unstressed state. Naturally, the end effector can translate with reference to the first fixed element.;
- a coupling arrangement linked to said end effector, to said intermediate stage, and to a fixed element (which may be the first fixed element or another fixed element such as a fixed base element), said coupling arrangement being arranged so as to substantially prevent said end effector from displacing perpendicular to said first plane.

As a result, the end effector can move substantially parallel to the first plane with two degrees of freedom in translation, parasitic translations perpendicular to the first plane as well as rotations about at least the X and Y axes having been substantially eliminated. Rotation in the first plane (i.e. about an axis Z perpendicular to this plane) may be permitted or may be blocked, depending on the construction. Furthermore, the use of first and second beams which are perpendicular to the first plane (i.e. which extend parallel to the Z direction) results in these elements being loaded in compression and tension, which enables the mechanism to support higher loads than would be the case if they were loaded in bending as is in the case in planar constructions. The mechanism is also simple and easy to construct.

In one embodiment, each of said first beams is rigidly linked to said end effector and to said intermediate stage, and each of said second beams is rigidly linked to said intermediate stage and to said first fixed element.

Advantageously, said coupling arrangement comprises a substantially rigid bar (which may be a single piece or two bars attached together), attached to each of said end effector, said intermediate stage and a fixed element in such a manner as to provide with respect to each of the end effector and said intermediate stage:
- two degrees of freedom of rotation around axes parallel to said first plane;
- one degree of freedom in translation perpendicular to said first plane;
- substantially no degree of freedom in rotation about an axis perpendicular to said first plane; and
- substantially no degree of freedom in translation parallel to said first plane.

Furthermore, said bar is attached to a fixed base element in such a manner so as to provide with respect to said fixed base element:
- two degrees of freedom of rotation around axes parallel to said first plane;
- substantially no degree of freedom in translation perpendicular to said first plane;
- preferably substantially no degree of freedom in rotation about an axis perpendicular to said first plane, which hence prevents rotation of the end effector about the same axis; and
- substantially no degree of freedom in translation parallel to said first plane..

Advantageously, said substantially rigid bar is attached to each of said end effector, said intermediate stage and said fixed base element by means of a flexure arrangement comprising three rod flexures arranged to be able to bend parallel to said first plane, said rod flexures extending tangentially from a central portion to said end effector or said intermediate stage (as is the case), and wherein said substantially rigid bar is furthermore attached to said fixed base element by means of a polar beam extending coaxially to said substantially rigid bar and rigidly fixed to said fixed base element.

In another embodiment, each of said first beams is linked to said end effector and to said intermediate stage by a joint permitting at least two degrees of freedom in rotation parallel to said first plane and optionally a third degree of freedom in rotation perpendicular to said first plane, and substantially no degree of freedom in translation perpendicular to said first plane, and each of said second beams is linked to said intermediate stage and to said first fixed element by a joint permitting at least two degrees of freedom in rotation parallel to said first plane and optionally a third degree of freedom in rotation perpendicular to said first plane, and substantially no degree of freedom in translation perpendicular to said first plane, said joints preferably allowing substantially no degrees of freedom in translation.

Advantageously, said coupling arrangement comprises at least three subcouplers disposed in a rotationally-symmetrical fashion, each subcoupler comprising:
- a first fixation point fixed to said end effector and linked to a substantially rigid coupling beam by means of at least one flexure or flexure assembly;
- a second fixation point fixed to said intermediate stage and linked to said coupling beam by means of at least one flexure or flexure assembly; and
- a third fixation point fixed to said first fixed element and linked to said coupling beam by at least one flexure or flexure assembly,
wherein said coupling arrangement is configured to prevent translation of said first fixation point and said second fixation point with respect to the first fixed element in a direction perpendicular to a direction of extension of said coupling beam.

Advantageously, said subcouplers are mounted in contact with said end effector and said intermediate stage.

Advantageously, said end effector and said first fixed element are substantially coplanar.

### Brief description of the drawings

Further details of the invention will become apparent upon reading the detailed description below, in reference to the annexed figures in which:
- Figure 1 is a partially cutaway isometric view of a first embodiment of a flexure mechanism according to the invention;
- Figure 2 is an isometric view of an interface between the coupling bar and the intermediate stage of the construction of figure 1;
- Figure 3 is a side view showing the construction of figure 1 in unstressed and displaced positions;
- Figure 4 is an isometric view of a second embodiment of a flexure mechanism according to the invention;
- Figure 5 is a cutaway isometric view of the flexure mechanism of figure 4;
- Figure 6 is an exploded isometric view of the flexure mechanism of figure 4;
- Figure 7 is an isometric detail view of a joint of the embodiment of figures 4-6; and
- Figure 8 is an isometric detail view of a variant of a joint of the embodiment of figures 4-6.

### Embodiments of the invention

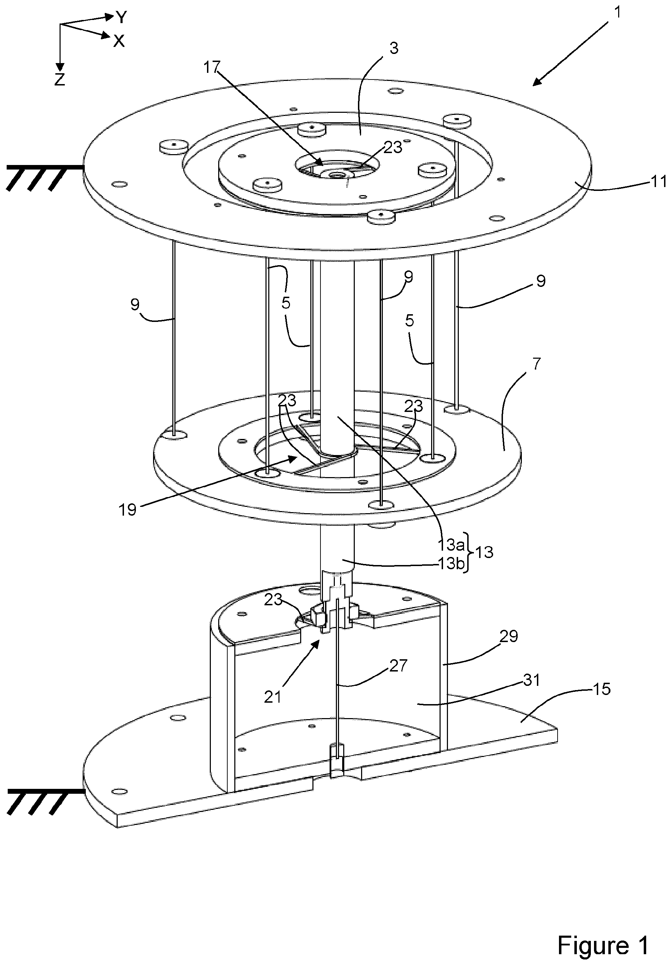

Figure 1 illustrates an embodiment of a flexure mechanism 1 according to the invention in an unstressed state. This mechanism 1 comprises an end effector 3 arranged to be able to move substantially with only two degrees of freedom in translation in a first plane, defined here as the XY plane, and with substantially no degrees of freedom in rotation, all parasitic translations and rotations having been substantially eliminated to the order of 2%o or less of the displacement in the X-Y plane. As a result, the mechanism 1 is of the type typically known as an "XY table".

As a general rule, an element is considered "flexible if it is intended to undergo deformation in use, and "rigid" if it is not. To parametrise this, a "rigid" element has a stiffness which is at least 100 times higher than a "flexible" element, and it is naturally possible for an element to be flexible in one direction and rigid in another, as in the case of a blade flexure which is flexible in bending in one plane, and rigid in tension/compression as well as in bending perpendicular to said plane. Likewise, a flexible beam of circular cross section is flexible in bending but rigid in tension/compression.

In the following description, the construction of the mechanism 1 will be described following the logic of its conception, in order to clearly illustrate the means by which parasitic displacements in translation and rotation are eliminated. Furthermore, unless otherwise stated, the relationship between the various components is described in the unstressed state of the mechanism 1, i.e. the state illustrated in figure 1.

Starting at the end effector 3, which comprises a plate of annular form (although other shapes are possible) extending in a first plane parallel to the XY plane, this element is primarily supported by at least three first beams 5, which extend substantially parallel to one another in the Z direction (i.e. perpendicular to the first plane XY) when the mechanism 1 is in an unstressed state. The first beams 5 of this embodiment are flexible, and are each rigidly attached at a first of their extremities to the end effector 3, and at a second of their extremities to an intermediate stage 7, and are hence built-in at each end, with zero degrees of freedom with respect to the element to which they are attached. The first beams 5 as illustrated are of circular cross section (although this does not have to be the case, polygonal cross sections, open wireframe or cellular designs and similar being also applicable), and are regularly angularly distributed around the end effector 5 such that they are all equidistant from a central point of action, although this does not have to be the case so long as the first beams 5 are arranged in a polygon and not in a straight line. Furthermore, more than three first beams are possible, however by providing exactly three, the structure is not hyperstatic, and is simpler and easier to fabricate.

If the arrangement of end effector 3 and first beams 5 had simply been attached to an immovable element, a displacement parallel to the XY plane would result in a parasitic displacement in the Z direction (i.e. downwards in the orientation of the figures).

By attaching the first beams 5 to the intermediate stage 7, part of this parasitic movement can be eliminated. Intermediate stage 7 is fixed by means of flexible second beams 9 to a first fixed element 11, which is substantially coplanar (or close to coplanar) with the end effector 3 and is fixed to a rigid frame (not illustrated; indicated schematically by the "ground" symbol). Second beams 9 are subject to the same constraints as first beams 5, mutatis mutandis, and extend parallel thereto. In the ideal case, first beams 5 and second beams 9 are substantially identical in terms of length (and also optionally in terms of stiffness), in order for the parasitic motions to cancel out.

As a result, the intermediate stage 7 is suspended from the rigid frame and when the end effector 3 tries to descend (i.e. to translate downwards in the Z direction), the intermediate stage tends to rise (i.e. to translate upwards in the Z direction) towards the fixed element 11, and hence counteract the parasitic Z-direction translation of the end effector 3.

However, the part of the mechanism 1 described up to now still retains an undesired degree of freedom, namely that of a rotation about the Z axis.

This is compensated by means of coupling arrangement 13, which is substantially rigid and in the illustrated embodiment is arranged equidistant from each of the first beams 5 such that it lies on the central axis Z of the mechanism 1, although its location can be chosen at will.

This coupling arrangement 13 comprises an upper substantially rigid straight bar 13a linking the end effector 3 to the intermediate stage 7, and a lower substantially rigid bar 13b linking the intermediate stage 7 to a fixed base element 15 attached to the previously-mentioned rigid frame (again, not illustrated). However, a single-piece substantially rigid bar construction is also possible.

The coupling arrangement 13 is not attached rigidly to each of the end effector 3, the intermediate stage 7 and the base element 15. On the contrary, its interface 17, 19, 21 with each of these elements is subject to certain constraints, which will be described below.

At each of the interfaces 17, 19 with the end effector 3 and the intermediate stage 7, each corresponding interface has two degrees of freedom in rotation about the X and Y axes, as well as one degree of freedom in translation along the Z axis, the other potential degrees of freedom being substantially blocked.

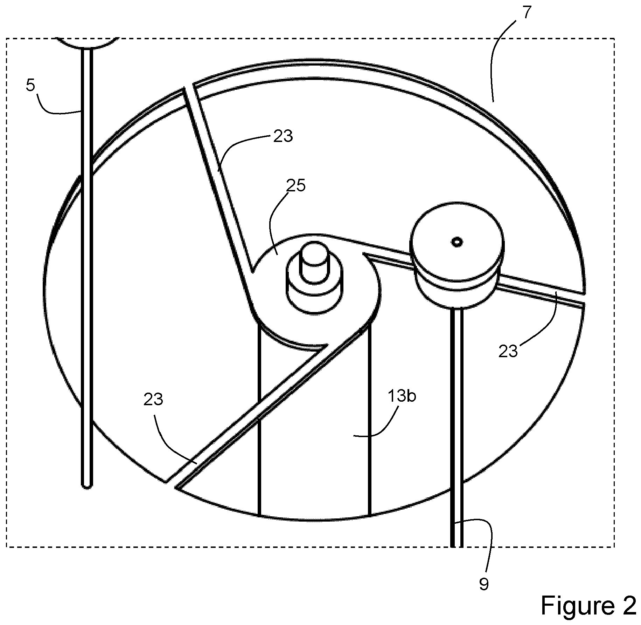

Various possible flexure-based or sliding bearings are possible to attain these degrees of freedom, however one particularly advantageous flexure based arrangement is illustrated on figures 1 and 2, the latter of which illustrates interface 19 with the intermediate stage 7.

This flexure arrangement comprises three rod flexures 23 which extend tangentially from a central portion 25 towards the intermediate stage, these rod flexures 23 being configured so as to be able to bend in directions which are perpendicular to the first plane. These blade flexures 23 can be integral with the intermediate stage, or fixed thereto, e.g. via an annular fixing ring, and the coupling arrangement 13 is rigidly fixed to the central portion 25, and may have a circular or polygonal (e.g. square or rectangular) cross-section.

As a result, the flexibility of the rod flexures 23 allows tipping between the coupling arrangement 13 and the intermediate stage 7 around both axes parallel to the first plane XY, as well as a translation along the Z axis. However, due to the tangential rather than radial arrangement of the rod flexures 23, a rotation about the Z axis is countered since it puts the rod flexures 23 in tension or compression, depending on the direction of rotation. Furthermore, X and Y translations are also substantially prevented for the same reasons.

The interface 17 with the end effector 3 is substantially identical to the interface 19 with the intermediate stage 7, and hence need not be described in detail.

The interface 21 between the coupling arrangement 13 and the rigid base element has an additional constraint, namely that displacement in the Z direction is prevented. This can be attained in many ways, such as by means of a universal joint (cardan) or a constant velocity joint, which is essentially the arrangement of beams of the interfaces 17 and 19 as described above, with the addition of a polar beam extending along the extension of the axis of the coupling arrangement 13 and rigidly attached to an extremity of this latter and also to the fixed base element 15 (which constitutes a second fixed element attached to a frame or similar). To this effect, base element 15 comprises a cylindrical extension 29 to which the rod flexures 23 are attached and which defines a cavity 31 through which polar beam 27 passes.

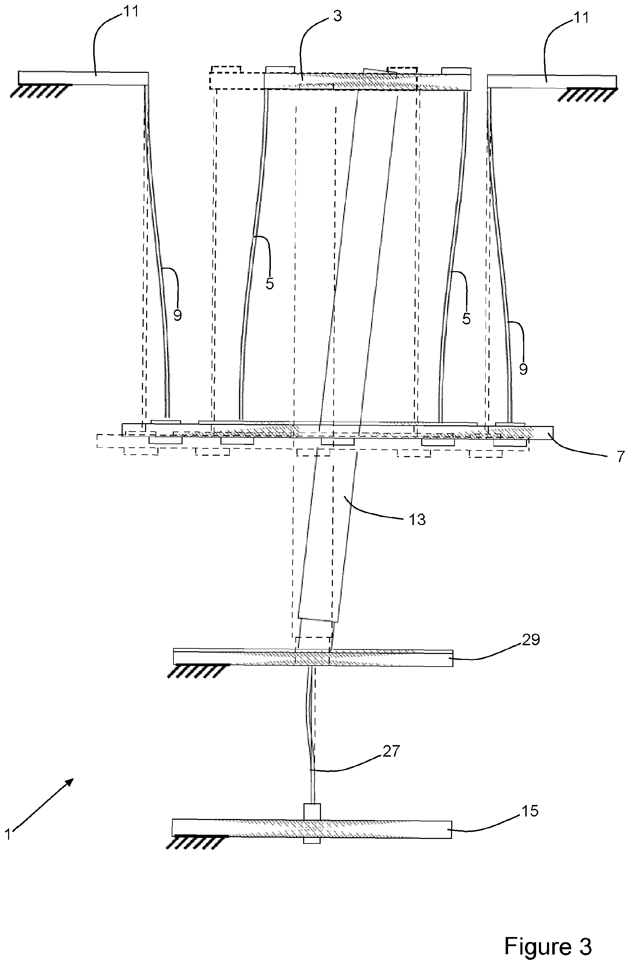

Figure 3 is a schematic modelisation of the mechanism 1 of figure 1 representing a side view with two of the three first beams 5 and two of the second beams 9 being shown for clarity. This modelisation illustrates the effect of displacing the end effector 3 from its initial position (dotted lines) to the right. It can be seen that following this translational displacement of the end effector 3, there is essentially no parasitic rotation or translation in the Z direction of the end effector 3, whereas the intermediate stage 7 does have a parasitic Z-axis displacement, causing it to rise.

When applying relatively large loads to the end effector 3, since the first beams 5 are in compression and the second beams 9 are in tension, they have relatively high stiffness compared to a planar prior art construction in which the flexures are loaded in bending. As a result, the arrangement illustrated has significantly reduced unwanted deformation in such cases.

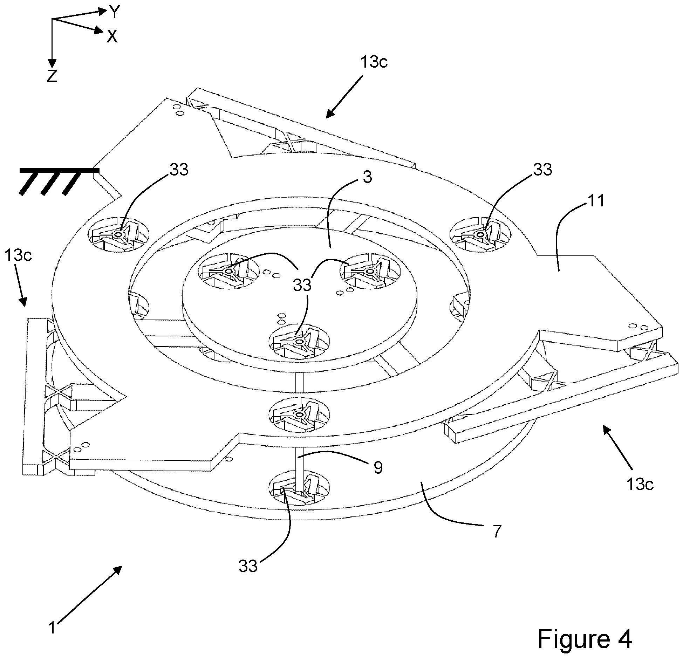

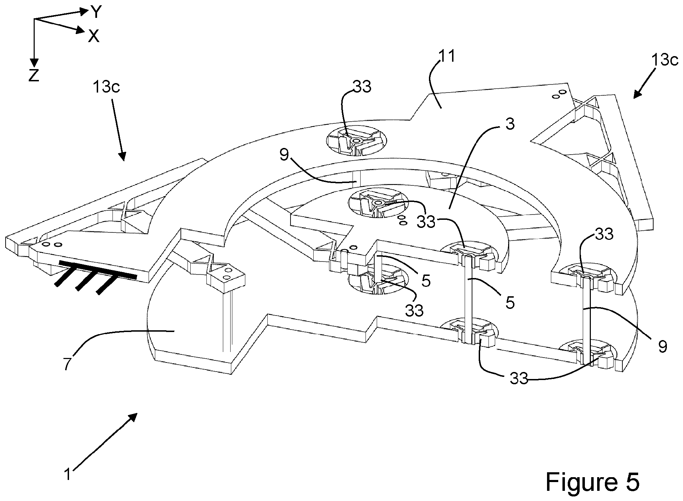

Figures 4-6 illustrate a second embodiment of a flexure mechanism 1 according to the invention, which will be described in terms of how it differs from the embodiment of figures 1-3, the same or equivalent features being indicated with the same reference signs.

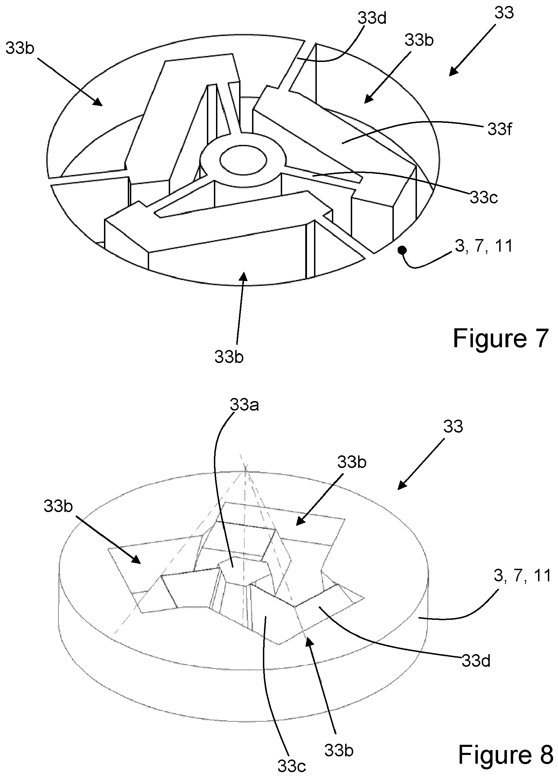

Globally, the arrangement of end effector 3, first beams 5, intermediate stage 7, second beams 9 and first fixed element 11 remains unchanged, aside from the fact that in this embodiment the beams 5, 7 may be either flexible as in the previous embodiment or may be substantially rigid. However, rather than being rigidly fixed (i.e. built in) to the end effector 3, intermediate stage 7 and first fixed element 11, each of the beams 5, 9 is attached thereto by a joint 33 allowing three degrees of freedom in rotation around the X, Y and Z axes, i.e. a limited displacement ball-joint type arrangement. In the illustrated embodiment this is a flexure-based joint 33, illustrated in more detail in figure 7.

Joint 33 comprises an inner section 33a into which the corresponding beams 5, 9 is rigidly fitted (e.g. by force fitting, gluing or similar), which is joined to the body of the element 3, 7, 11 in question by means of a rotationally-symmetrical flexure arrangement comprising three sets of flexures 33b. Each set of flexures 33b comprises a first blade flexure 33c extending radially from the inner section 33a, and a second blade flexure 33d which extends radially from the element 3, 7, 11 in question towards the inner section 33a, 90° offset to the first blade flexure 33c. The extremities of the two blade flexures 33c, 33d are linked by a rigid bar 33f. As a result, the inner section 33a can pivot in any direction (i.e. about the X, Y and Z directions) and can furthermore translate parallel to the first plane XY, but substantially not translate along the axis Z of the corresponding beam 5, 9.

Figure 8 illustrates a variation of such a joint 33, in which the first and second blade flexures 33c, 33d are joined directly to one another and are rotated at an oblique angle to the Z axis°, which has exclusively three degrees of freedom in rotation and substantially zero in translation.

As an alternative, for each pair of joints 33 associated with a given beam 5, 9, one of the two joints 33 may be blocked in Z-rotation, and hence only have degrees of freedom in rotation about the X and Y axes.

Returning now to the construction of the mechanism 1 of this embodiment, the coupling arrangement 13 comprises three subcouplers 13c arranged in a rotationally symmetric fashion with respect to the central Z axis, although four or more are possible at the price of the arrangement being hyperstatic.

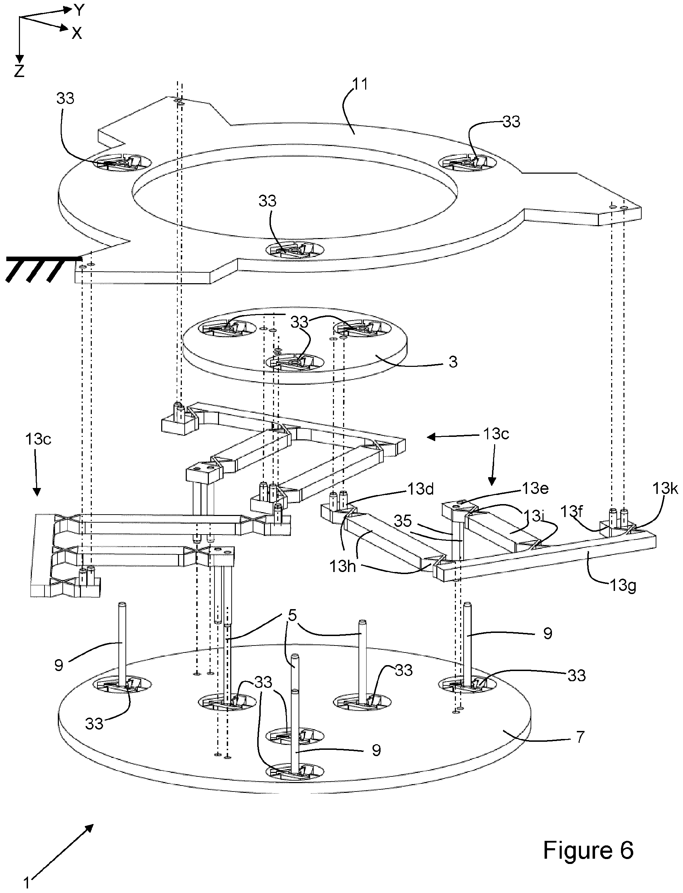

Each subcoupler 13c comprises (see the subcoupler front right on figure 6, which is the only one provided with a full set of reference signs so as not to overload the figures):
- a first fixation point 13d, adapted to be fixed to the end effector 3 with substantially zero degrees of freedom, e.g. by means of a pair of pins rigidly fitted into corresponding openings;
- a second fixation point 13e, adapted to be fixed to the intermediate stage 7 by means of a pair of longer rods 35;
- a third fixation point 13f, similar to the first fixation point 13d but adapted to be fixed to the first fixed element 11, again by means of a pair of pins or similar.

Each of the first and second fixation points 13d, 13e, are fixed to a coupling beam 13g by means of a corresponding flexure-beam-flexure assembly 13h, 13i, which in the illustrated embodiment each comprise crossed blade flexures at each end of a substantially rigid beam, but other arrangements of flexures are possible such as simple beam or blade flexures. Third fixation point 13f is attached to the coupling beam 13g by a crossed pivot flexure 13k, but again other arrangements are possible.

In an unstressed state, each flexure-beam-flexure assembly 13h, 13i extends substantially orthogonally to the coupling beam 13g, and the subcoupler 13c is mounted in contact with the end effector 3 and first fixed element 11, although this does not have to be the case, and indeed can only be the case when end effector 3 and first fixed element 11 are coplanar. In other cases longer rods will be used to connect at least one of the first and third fixation points 13d, 13f to the corresponding element 3, 11. It should also be noted that the various elements of each subcoupler 13c do not need to be coplanar.

When attached to the corresponding elements, the various fixation points 13d, 13e, 13f of each type are evenly distributed angularly around the corresponding element 3, 7, 11, in a similar manner to the first and second beams 5, 9.

The configuration of each subcoupler 13c is such that each fixation point 13d, 13e, 13f is prevented from translating parallel to the first plane in a direction orthogonal to the direction of extension of the corresponding coupling beam 13g. However, coupling beam 13g can pivot in response to displacements to allow the end effector 3 and intermediate stage 7 to translate parallel to the first plane. As a result, parasitic displacements of the end effector 3 are eliminated.

With this construction, the same effect is produced as with the embodiment of figure 1, although a rotation of the end effector about an axis perpendicular to the first plane is also permitted (i.e. around the Z axis), which is not problematic for most applications and can even be controlled if a rotation in the XY plane is desired. However, the arrangement of this embodiment can be significantly more compact in the Z direction due to the planar construction of the coupling arrangement 13.

In each of the above-described embodiments, it is possible to dynamically balance the structure by providing counterweights at convenient locations on one or more of the end effectors 3, intermediate stage 11, and/or any actuators if present (see below). Furthermore, the overall stiffness of the arrangement can be reduced by constraining the various elastic elements as is generally known (e.g. by stressing them in compression), in particular the beams 5, 7 of the first embodiment since these are flexible. This can be carried out by means known in the art, such as tension springs arranged so as to cause the beams 5, 7 to be compressed.

In terms of materials, the mechanism 1 of the invention can be constructed in metal, polymer, silicon, photostructurisable glass, alumina, silicon oxide etc. or any suitable combination thereof depending on the dimensions and application, and can be assembled from individual components or 3D printed.

If present, actuators (not illustrated) of any convenient type can be fixed to the first fixed element (or indeed to any fixed element), in order to cause the end effector 3 to displace in translation parallel to the first plane with respect to the first fixed element 11.

Particular applications of the flexure mechanism 1 of the invention include, but are not limited to:
- positioning of optical components (lenses, beam splitters, etc.);
- 3D femto laser printing: positioning of the block of glass or the laser for 3D machining of glass;
- 3D printing of biological structures;
- Electric discharge machining (EDM): positioning of either the part being machined or of the electrode. The design is particularly interesting for wire EDM as the end effector 3 will always remain horizontal even if there is a parasitic motion in the Z direction (i.e. perpendicular to the first plane);
- Positioning of wafers and masks for photolithography;
- Positioning of mould for imprinting (ex: UV imprinting);
- As a platform for haptics.

Although the invention has been described with respect to specific embodiments, variations thereto are possible without departing from the scope of the invention as defined by the appended claims. In particular, it is noted that other configurations of interfaces 17, 19, 23 and joints 33 are possible, whether based on flexures or conventional frictional structures, provided that the degrees of freedom and blocked translations/rotations are present as explained above.

## Claims

1. Flexure mechanism (1) comprising:
- an end effector (3) arranged to be able to move in a first plane (XY);
- an intermediate stage (7) linked to said end effector (3) by means of at least three first beams (5) extending substantially perpendicular to said first plane (XY) when the flexure mechanism (1) is in an unstressed state, said intermediate stage (7) being arranged to at least translate parallel to said first plane (XY);
- a first fixed element (11) linked to said intermediate stage (5) by means of at least three second beams (9) extending substantially perpendicular to said first plane (XY) when the flexure mechanism (1) is in an unstressed state;
- a coupling arrangement (13, 13a, 13b; 13c) linked to said end effector (3), to said intermediate stage (7), and to a fixed element (11, 15,29), said coupling arrangement (13, 13a, 13b; 13c) being arranged so as to substantially prevent said end effector (3) from displacing perpendicular to said first plane (XY).

2. Flexure mechanism (1) according to claim 1, wherein each of said first beams (5) is rigidly linked to said end effector (3) and to said intermediate stage (7), and each of said second beams (9) is rigidly linked to said intermediate stage (7) and to said first fixed element (11).

3. Flexure mechanism (1) according to claim 2, wherein said coupling arrangement (13) comprises a substantially rigid bar (13a, 13b) attached to each of said end effector (3), said intermediate stage (7) and a fixed element (15, 29) in such a manner as to provide with respect to each of the end effector (3) and said intermediate stage (7):
- two degrees of freedom of rotation around axes (X, Y) parallel to said first plane (XY);
- one degree of freedom in translation perpendicular to said first plane (XY);
- substantially no degree of freedom in rotation about an axis (Z) perpendicular to said first plane (XY); and
- substantially no degree of freedom in translation parallel to said first plane (XY), and wherein said bar (13a, 13b) is attached to a fixed base element (15, 29) in such a manner so as to provide with respect to said fixed base element (15, 29):
- two degrees of freedom of rotation around axes (X, Y) parallel to said first plane (XY);
- substantially no degree of freedom in translation perpendicular to said first plane (XY);
- preferably substantially no degree of freedom in rotation about an axis (Z) perpendicular to said first plane (XY); and
- substantially no degree of freedom in translation parallel to said first plane (XY).

4. Flexure mechanism (1) according to claim 3, wherein said substantially rigid bar (13, 13b) is attached to each of said end effector (3), said intermediate stage (7) and said fixed base element (15, 29) by means of a flexure arrangement comprising three rod flexures (23) arranged to be able to bend parallel to said first plane, said rod flexures (23) extending tangentially from a central portion (25) to said end effector (3) or said intermediate stage (7), and wherein said substantially rigid bar (13a, 13b) is furthermore attached to said fixed base element (15, 29) by means of a polar beam (27) extending coaxially to said substantially rigid bar (13a, 13b) and rigidly fixed to said fixed base element (15, 29).

5. Flexure mechanism (1) according to claim 1, wherein each of said first beams (5) is linked to said end effector (5) and to said intermediate stage (7) by a joint (33) permitting at least two degrees of freedom in rotation parallel to said first plane and optionally a third degree of freedom in rotation perpendicular to said first plane (XY), and substantially no degree of freedom in translation perpendicular to said first plane (XY), and each of said second beams (9) is linked to said intermediate stage (7) and to said first fixed element (11) by a joint (33) permitting at least two degrees of freedom in rotation parallel to said first plane and optionally a third degree of freedom in rotation perpendicular to said first plane (XY), and substantially no degree of freedom in translation perpendicular to said first plane (XY), said joints (33) preferably allowing substantially no degrees of freedom in translation.

6. Flexure mechanism (1) according to claim 5, wherein said coupling arrangement comprises at least three subcouplers (13c) disposed in a rotationally-symmetrical fashion, each subcoupler (13c) comprising:
- a first fixation point (13d) fixed to said end effector (3) and linked to a substantially rigid coupling beam (13g) by means of at least one flexure (13h);
- a second fixation point (13e) fixed to said intermediate stage (7) and linked to said coupling beam (13g) by means of at least one flexure (13j); and
- a third fixation point (13f) fixed to said first fixed element (11) and linked to said coupling beam (13g) by at least one flexure (13k),
wherein said coupling arrangement (13c) is configured to prevent translation of said first fixation point (13d) and said second fixation point (13e) with respect to the first fixed element (11) in a direction perpendicular to a direction of extension of said coupling beam (13g).

7. Flexure mechanism (1) according to claim 6, wherein said subcouplers (13c) are mounted in contact with said end effector (3) and said intermediate stage (7).

8. Flexure mechanism (1) according to any preceding claim, wherein said end effector (3) and said first fixed element (11) are substantially coplanar.
